# EUROPEAN PATENT SPECIFICATION

(11) **EP 1 435 021 B1**
(45) Date of publication and mention of the grant of the patent: **15.06.2005**
(21) Application number: 02784166.7
(22) Date of filing: 09.10.2002
(51) Int. Cl.: G03F 7/004, G03F 7/033, G03F 7/038, H01J 9/02

(54) **AQUEOUS DEVELOPABLE PHOTOIMAGEABLE THICK FILM COMPOSITIONS FOR MAKING PHOTOIMAGEABLE BLACK ELECTRODES**
WÄSSRIG ENTWICKELBARE, LICHTEMPFINDLICHE DICKSCHICHTBILDAUFZEICHNUNGSZUSAMMENSETZUNGEN ZUR HERSTELLUNG VON SCHWARZEN ELEKTRODEN
COMPOSITIONS DE COUCHES EPAISSES PHOTO-IMAGEABLES, DEVELOPPABLES ET AQUEUSES POUR LA FABRICATION D'ELECTRODES NOIRES PHOTO-IMAGEABLES

(30) Priority: 12.10.2001 US 328734 P
(43) Date of publication of application: 07.07.2004
(73) Proprietor: E.I. DU PONT DE NEMOURS AND COMPANY, Wilmington, Delaware 19898 (US)
(72) Inventor: SUESS, Terry, R., Raleigh, NC 27614 (US); SMITH, Jerome, David, Cary, NC 27513 (US); YANG, Haixin, Chapel Hill, NC 27516 (US)
(74) Representative: Towler, Philip Dean
(86) International application number: PCT/US2002/033399
(87) International publication number: WO 2003/032088

(56) References cited:
- EP-A- 0 935 275
- EP-A- 1 168 079
- US-A- 6 120 975
- US-A- 6 156 433

## Description

### FIELD OF THE INVENTION

The invention is directed to a photoimageable thick film composition for use in photo-patterning methods, and more particularly, to a composition utilizing RuO₂ and/or ruthenium based polynary oxides and photocrosslinkable polymers used in making photoimageable black electrodes in plasma display panels.

### BACKGROUND OF THE INVENTION

Since it is the trend in the industry to make smaller and cheaper electronic devices and provide higher resolution for performance, it has become necessary to develop new photoimageable materials to manufacture such devices. Photo-patterning technologies offer uniform finer lines and space resolution when compared to traditional screen-printing methods. A photo-patterning method, such as DuPont's FODEL® printing system, utilizes a photoimageable organic medium as found in patents U.S. 4,912,019; U.S. 4,925,771; and U.S. 5,049,480, whereby the substrate is first completely covered (printed, sprayed, coated or laminated) with the photoimageable thick film composition and dried. An image of the pattern is generated by exposure of the photoimageable thick film composition with actinic radiation through a photomask bearing a pattern. The exposed substrate is then developed. The unexposed portion of the pattern is washed away leaving the photoimaged thick film composition on the substrate that is then fired to remove organic materials and sinter inorganic materials. Such a photo-patterning method demonstrates line resolution of about 30 microns depending on the substrate smoothness, inorganic particle size distribution, exposure and development variables. It has been proven that such a technique is useful in the manufacture of plasma display panels.

Resolution and brightness of the images in the AC plasma display panel (PDP) device depend on electrode width, interconnecting conductor pitch and transparency of the dielectric layer. It is difficult to obtain fine line and space resolution for the formation of the electrodes and interconnecting conductor patterns when these materials are applied by conventional patterning techniques such as screen printing, sputtering or chemical etching methods. Moreover, to improve the display contrast, it is essential to decrease the reflection of external light from the electrodes and conductors arranged on the front glass substrate. This reflection decrease can be most easily accomplished by making the electrodes and conductors black as viewed through the front plate of the display.

The present invention is directed to a black electrode composition containing photocrosslinkable polymers for use in a PDP device fabricated by using photoimageable thick film conductor compositions for use in photo-patterning methods wherein the black electrode is present between the substrate and a conductor electrode arrangement as described in US Patent Nos. 5,851,732 and 6,075,319.

### SUMMARY OF THE INVENTION

The invention is directed to a photoimageable composition comprising:
(I) finely divided particles of inorganic material comprising:
   (a) conductive particles selected from RuO₂, ruthenium-based polynary oxides or mixtures thereof;
   (b) inorganic binder having a glass transition temperature in the range of from 325 to 600°C, a surface area of no greater than 10 m²/g and at least 85 wt. % of the particles having a size in the range of 0.1-10 µm;
   dispersed in:
(II) an organic medium comprising;
   (a) aqueous developable photocrosslinkable polymer which is a copolymer, interpolymer or mixture thereof, wherein each copolymer or interpolymer comprises (1) a nonacidic comonomer comprising a C₁₋₁₀ alkyl acrylate, C₁₋₁₀ alkyl methacrylate, styrenes, substituted styrenes or combination thereof and (2) an acidic comonomer comprising ethylenically unsaturated carboxylic acid containing moiety, wherein 2-20% of the carboxylic acid containing moiety is reacted with a reactive molecule having a first and second functional unit wherein the first functional unit is a a vinyl group and the second functional unit is capable of forming a chemical bond by reaction with the carboxylic acid moiety; forming the copolymer, interpolymer or mixture thereof having an acid content of at least 10 wt. % of the total polymer weight; a glass transition temperature of 50-150°C and a weight average molecular weight in the range of 2,000-250,000;
   (b) photoinitiation system; and
   (c) organic solvent.

### DETAILED DESCRIPTION

The composition of the present invention uses photocrosslinkable polymers in conjunction with inorganic materials such as electrically conductive particles and glass frit dispersed in organic medium. The main components of the photoimageable black electrode composition will be discussed herein below.

### I. Inorganic Materials

### A. Electrically Conductive Particles

The conductive black compositions of the invention contain RuO₂ and/or ruthenium based polynary oxides as a conductive component. The conductive particles may optionally contain precious metals including gold, silver, platinum, palladium, copper or combinations thereof. Ruthenium based polynary oxides are one type of pyrochlore oxide that is a multicomponent compound of Ru⁺⁴, Ir⁺⁴, or their mixture (M") represented by the following general formula

(MₓBi₂₋ₓ)(M'_{y}M"_{2-y})O_{7-z}

M is chosen from a group consisting of yttrium, thallium, indium, cadmium, lead, copper, and rare earth materials,
M' is chosen from a group consisting of platinum, titanium, chromium, rhodium, and antimony,
M" is ruthenium, iridium or their mixture,
x is 0-2 but x ≤1 for univalent copper,
y is 0-0.5 but when M' is rhodium or is more than 1 of platinum, titanium, chromium, rhodium, or antimony, y is 0-1, and
z is 0-1 but when M is bivalent lead or cadmium, this is at least equal to about x/2.

The ruthenium pyrochlore oxides are found in detail in U.S. Patent No. 3,583,931 which is incorporated herein by reference.

Preferable ruthenium polynary oxides are bismuth ruthenate Bi₂Ru₂O₇, lead ruthenate Pb₂Ru₂O₆, Pb_{1.5}Bi_{0.5}Ru₂O_{6.5}, PbBiRu₂O_{6.75} and GdBiRu₂O₆. These materials can easily be obtained in pure form, they are not adversely affected by glass binders and are stable even when heated to about 1000°C in air.
The ruthenium oxides and/or ruthenium pyrochlore oxides are used in proportions of 4-50 wt %, preferred 6-30%, more preferred 5-15% and most preferred 9-12%, based on the weight of the entire composition including the organic medium.

Electrically conductive metals may be optionally added to the black composition. Virtually any shape metal powder, including spherical particles and flakes (rods, cones, and plates) may be used in practicing the invention. The preferred metal powders are gold, silver, palladium, platinum, copper or combinations thereof. It is preferred that the particles be spherical. It has been found that the dispersion of the invention must contain no significant amount of solids having a particle size of less than 0.1 µm. When particles of this small size are present it is difficult to adequately obtain complete burnout of the organic medium when the films or layers thereof are fired to remove the organic medium and to effect sintering of the inorganic binder and the metal solids. When the dispersions are used to make thick film pastes, which are usually applied by screen printing, the maximum particle size must not exceed the thickness of the screen. It is preferred that at least 80 percent by weight of the conductive solids fall within the 0.5-10 µm range.

In addition, it is preferred that the surface area of the conductive particles not exceed 20 m²/g, preferably not exceed10 m²/g and more preferably not exceed 5 m²/g. When metal particles having a surface area greater than 20 m²/g are used, the sintering characteristics of the accompanying inorganic binder are adversely affected. It is difficult to obtain adequate burnout and blisters may appear.

Often, copper oxide is added to improve adhesion. The copper oxide should be present in the form of finely divided particles, preferably ranging in size from about 0.1 to 5 microns. When present as Cu₂O, the copper oxide comprises from about 0.1 to about 3 percent by weight of the total composition, and preferably from about 0.1 to 1.0 percent. Part or all of the Cu₂O may be replaced by molar equivalents of CuO.

### B. Inorganic Binder

The electrically conductive powders described herein above are finely dispersed in an organic medium and are accompanied by inorganic binders and are optionally accompanied by metal oxides, ceramics, and fillers, such as other powders or solids. The function of an inorganic binder in a composition is binding the particles to one another and to the substrate after firing. Examples of inorganic binders include glass binders (frits), metal oxides and ceramics. Glass binders useful in the composition are conventional in the art. Some examples include borosilicate and aluminosilicate glasses. Examples further include combinations of oxides, such as: B₂O₃, SiO₂, Al₂O₃, CdO, CaO, BaO, ZnO, SiO₂, Na₂O, Li₂O, PbO, and ZrO which may be used independently or in combination to form glass binders. Typical metal oxides useful in thick film compositions are conventional in the art and can be, for example, ZnO, MgO, CoO, NiO, FeO, MnO and mixtures thereof.

The glass frits most preferably used are the borosilicate frits, such as lead borosilicate frit, bismuth, cadmium, barium, calcium, or other alkaline earth borosilicate frits. The preparation of such glass frits is well known and consists, for example, in melting together the constituents of the glass in the form of the oxides of the constituents and pouring such molten composition into water to form the frit. The batch ingredients may, of course, be any compounds that will yield the desired oxides under the usual conditions of frit production. For example, boric oxide will be obtained from boric acid, silicon dioxide will be produced from flint, barium oxide will be produced from barium carbonate, etc. The glass is preferably milled in a ball mill with water to reduce the particle size of the frit and to obtain a frit of substantially uniform size. It is then settled in water to separate fines and the supernatant fluid containing the fines is removed. Other methods of classification may be used as well.

The glasses are prepared by conventional glassmaking techniques, by mixing the desired components in the desired proportions and heating the mixture to form a melt. As is well known in the art, heating is conducted to a peak temperature and for a time such that the melt becomes entirely liquid and homogeneous. The desired glass transition temperature is in the range of 325 to 600 °C.

It is preferred that at least 85 % the inorganic binder particles be 0.1-10 µm. The reason for this is that smaller particles having a high surface area tend to adsorb the organic materials and thus impede clean decomposition. On the other hand, larger size particles tend to have poorer sintering characteristics. It is preferred that the weight ratio of inorganic binder to total solids be in the range 0.1 to 0.75 and more preferably in the range 0.2 to 0.5.

### II. Organic Medium

The main purpose of the organic medium is to serve as a vehicle for dispersion of the finely divided solids of the composition in such form that it can readily be applied to a ceramic or other substrate. Thus, the organic medium must first be one in which the solids are dispersible with an adequate degree of stability. Secondly, the rheological properties of the organic medium must be such that they lend good application properties to the dispersion. The main components of the medium follow:

### A. Photocrosslinkable Organic Polymer

The polymer binder is important to the compositions of this invention. They have aqueous developability and give a high resolving power.

They are photocrosslinkable polymer binders. They are made of copolymer, interpolymer or mixtures thereof, wherein each copolymer or interpolymer comprises (1) a nonacidic comonomer comprising a C₁₋₁₀ alkyl acrylate, C₁₋₁₀ alkyl methacrylate, styrenes, substituted styrenes or combinations thereof and (2) an acidic comonomer comprising ethylenically unsaturated carboxylic acid containing moiety, wherein 2-20% of the carboxylic acid containing moiety is reacted with a reactive molecule having a first and second functional unit, wherein the first functional unit is a vinyl group and the second functional unit is capable of forming a chemical bond by reaction with the carboxylic acid moiety. Examples of the vinyl group include, but are not limited to methacrylate and acrylate groups. Examples of the second functional unit include, but are not limited to epoxides, alcohols and amines. The resultant copolymer, interpolymer or mixture thereof has an acid content of at least 10 wt. % of the total polymer weight; a glass transition temperature of 50-150°C and an weight average molecular weight in the range of 2,000-250,000 and all ranges contained within.

The presence of acidic comonomer components in the composition is important in this technique. The acidic functional group provides the ability to be developed in aqueous bases such as aqueous solutions of 0.4-2.0% sodium carbonate. When acidic comonomers are present in concentrations of less than 10%, the composition is not washed off completely with an aqueous base. When the acidic comonomers are present at concentrations greater than 30%, the composition is less resistant under development conditions and partial development occurs in the image portions. Appropriate acidic comonomers include ethylenically unsaturated monocarboxylic acids such as acrylic acid, methacrylic acid, or crotonic acid and ethylenically unsaturated dicarboxylic acids such as fumaric acid, itaconic acid, citraconic acid, vinyl succinic acid, and maleic acid, as well as their hemiesters, and in some cases their anhydrides and their mixtures. Because they are cleaner burning in low-oxygen atmospheres, methacrylic polymers are preferred over acrylic polymers.

When the nonacidic comonomers are alkyl acrylates or alkyl methacrylates as mentioned above, it is preferable that these nonacidic comonomers constitute at least 50 wt. %, preferably 70-75 wt. %, of the polymer binder. When the nonacidic comonomers are styrene or substituted sytrenes, it is preferable that these nonacidic comonomers constitute 50 wt. % of the polymer binder and that the other 50 wt. % is an acid anhydride such as the hemiester of maleic anhydride. A favorable substituted styrene is alpha-methylstyrene.

Although not preferable, the nonacidic portion of the polymer binder can contain up to about 50 wt. % of other nonacidic comonomers as substitutes for the alkyl acrylate, alkyl methacrylate, styrene, or substituted styrene portions of the polymer. Examples include acrylonitrile, vinyl acetate, and acrylamide. However, because it is more difficult for these to completely bum out, it is preferable that less than about 25 wt. % of such monomers in the total polymer binder are used. The use of single copolymers or combinations of copolymers as binders are recognized as long as each of these satisfies the various standards above. In addition to the above copolymers, adding small amounts of other polymer binders is possible. For examples of these, polyolefins such as polyethylene, polypropylene, polybutylene, polyisobutylene, and ethylene-propylene copolymers, polyvinyl alcohol polymers (PVA), polyvinyl pyrrolidone polymers(PVP), vinyl alcohol and vinyl pyrrolidone copolymers, as well as polyethers that are low alkylene oxide polymers such as polyethylene oxide can be cited.

The acidic comonomer provides the polymer with a reactive site to introduce a reactive molecule such as photocrosslinkable functional units. This is accomplished by utilizing 2-20% of the carboxylic acid containing moiety reacting with the reactive molecule that contains a vinyl unit, as shown in the schematic below. The final polymer has repeating units, as shown. These polymers are well known to those skilled in the art. 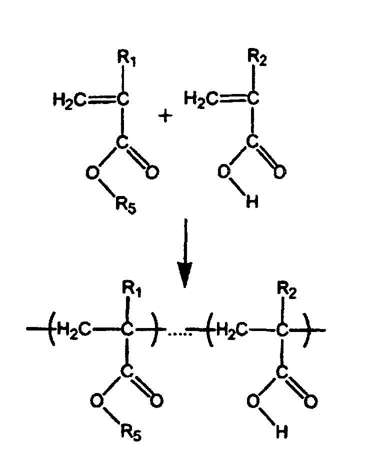 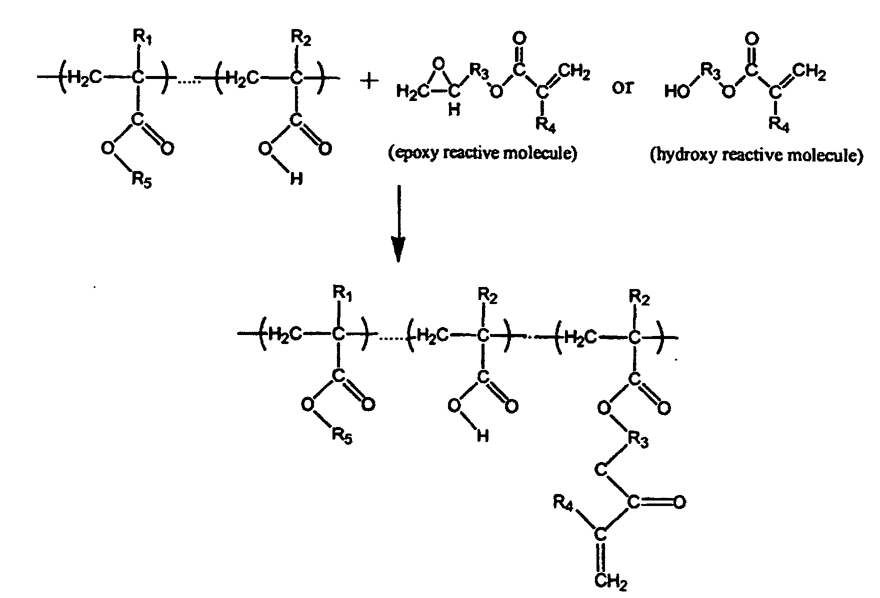 Where:
R₁, R₂ and R₄ are methyl group or hydrogen or a mixture thereof;
R₃ is a straight, branched or ring alkyl group which may contain aromatic groups or other atoms, for example, oxygen; and
R₅ is an alkyl (C₁-C₁₀).

The polymers described herein can be produced by those skilled in the art of acrylate polymerization by commonly used solution polymerization techniques. Typically, such acidic acrylate polymers are produced by mixing α- or β-ethylenically unsaturated acids (acidic comonomers) with one or more copolymerizable vinyl monomer (nonacidic comonomers) in a relatively low-boiling-point (75-150°C) organic solvent to obtain a 10-60% monomer mixture solution, then polymerizing the monomers by adding a polymerization catalyst and heating the mixture under normal pressure to the reflux temperature of the solvent. After the polymerization reaction is essentially complete, the acidic polymer solution produced is cooled to room temperature.

A reactive molecule, a free radical polymerization inhibitor and a catalyst are added to the cooled polymer solution described above. The solution is stirred until the reaction is complete. Optionally, the solution may be heated to speed up the reaction. After the reaction is complete and the reactive molecules are chemically attached to the polymer backbone, the polymer solution is cooled to room temperature, samples are collected, and the polymer viscosity, molecular weight, and acid equivalents are measured.

Furthermore, the weight average molecular weight of the polymer binder is in the range of 2,000-250,000 and any ranges contained therein. The molecular weight of the polymer binder will depend on the application. Weights less than 10,000 are generally useful in paste compositions and above 10,000 are generally useful in tapes or sheets. Polymers with molecular weight less than 10,000, generally have lower film forming ability. They may be used in tape formulations but generally require mixing with other compatible high molecular weight polymers to form a film or tape.

The total polymer in the composition is in the range of 5-70 wt. % based on total composition and any ranges contained therein.

### B. Photohardenable Monomer

Conventional photohardenable methacrylate monomers may be used in the invention. Depending on the application, it is not always necessary to include a monomer in the composition of the invention. Monomer components are present in amounts of 1-20 wt.%, based on the total weight of the dry photopolymerizable layer. Such preferred monomers include t-butyl acrylate and methacrylate, 1,5-pentanediol diacrylate and dimethacrylate, N,N-diethylaminoethyl acrylate and methacrylate, ethylene glycol diacrylate and dimethacrylate, 1,4-butanediol diacrylate and dimethacrylate, diethylene glycol diacrylate and dimethacrylate, hexamethylene glycol diacrylate and dimethacrylate, 1,3-propanediol diacrylate and dimethacrylate, decamethylene glycol diacrylate and dimethyacrylate, 1,4-cyclohexanediol diacrylate and dimethacrylate, 2,2-dimethylolpropane diacrylate and dimethacrylate, glycerol diacrylate and dimethacrylate, tripropylene glycol diacrylate and dimethacrylate, glycerol triacrylate and trimethacrylate, trimethylolpropane triacrylate and trimethacrylate, pentaerythritol triacrylate and trimethacrylate, polyoxyethylated trimethylolpropane triacrylate and trimethacrylate and similar compounds as disclosed in U.S. Patent No. 3,380,831, 2,2-di(p-hydroxy-phenyl)-propane diacrylate, pentaerythritol tetraacrylate and tetramethacrylate, 2,2-di-(p-hydroxyphenyl)-propane dimethacrylate, triethylene glycol diacrylate, polyoxyethyl-2,2-di-(p-hydroxyphenyl)propane dimethacrylate, di-(3-methacryloxy-2-hydroxypropyl)ether of bisphenol-A, di-(2-methacryloxyethyl) ether of bisphenol-A, di-(3-acryloxy-2-hydroxypropyl)ether of bisphenol-A, di-(2-acryloxyethyl)ether of bisphenol-A, di-(3-methacrloxy-2-hydroxypropyl)ether of 1,4-butanediol, triethylene glycol dimethacrylate, polyoxypropyltrimethylol propane triacrylate, butylene glycol diacrylate and dimethacrylate, 1,2,4-butanetriol triacrylate and trimethacrylate, 2,2,4-trimethyl-1,3-pentanediol diacrylate and dimethacrylate, 1-phenyl ethylene-1,2-dimethacrylate, diallyl fumarate, styrene, 1,4-benzenediol dimethacrylate, 1,4-diisopropenyl benzene, and 1,3,5-triisopropenyl benzene. Also useful are ethylenically unsaturated compounds having a weight average molecular weight of at least 300, e.g., alkylene or a polyalkylene glycol diacrylate prepared from an alkylene glycol of 2 to 15 carbons or a polyalkylene ether glycol of 1 to 10 ether linkages, and those disclosed in U.S. Patent No. 2,927,022, e.g., those having a plurality of free radical polymerizable ethylenic linkages particularly when present as terminal linkages. Particularly preferred monomers are polyoxyethylated trimethylolpropane triacrylate, ethylated pentaerythritol triacrylate, dipentaerythritol monohydroxypentaacrylate and 1,10-decanediol dimethlacrylate.

### C. Photoinitiation System

Suitable photoinitiation systems are those, which generate free radicals upon exposure to actinic light at ambient temperature. These include the substituted or unsubstituted polynuclear quinones which are compounds having two intracyclic carbon atoms in a conjugated carbocyclic ring system, e.g., 2-benzyl-2- (dimethylamino)-1-(4-morpholinophenyl)-1-butanone, 2,2-dimethoxy-2-phenylacetophenone, 9,10-anthraquinone, 2-methylanthraquinone, 2-ethylanthraquinone, 2-tert-butylanthraquinone, octamethylanthraquinone, 1,4-naphthoquinone, 9,10-phenanthrenequinone, benz (a) anthracene-7, 12-dione, 2,3-naphthacene-5,12-dione, 2-methyl-1,4-naphthoquinone, 1,4-dimethylanthraquinone, 2,3-dimethylanthraquinone, 2-phenylanthraquinone, 2,3-diphenylanthraquinone, retenequinone, 7,8,9,10-tetrahydronaphthracene-5,12-dione, and 1,2,3,4-tetrahydrobenz(a)anthracene-7,12-dione. Other photoinitiators which are also useful, even though some may be thermally active at temperatures as low as 85°C, are described in U.S. Patent No. 2,760,863 and include vicinal ketaldonyl alcohols such as benzoin, pivaloin, acyloin ethers, e.g., benzoin methyl and ethyl ethers; α-hydrocarbon-substituted aromatic acyloins, including α-methylbenzoin, α-allylbenzoin and α-phenylbenzoin, thioxanthone and/or thioxanthone derivatives and the appropriate hydrogen donors. Photoreducible dyes and reducing agents disclosed in U.S. Patent Nos. 2,850,445, 2,875,047, 3,097,096, 3,074,974, 3,097,097, and 3,145,104, as well as dyes of the phenazine, oxazine, and quinone classes, Michler's ketone, benzophenone, 2,4,5-triphenylimidazolyl dimers with hydrogen donors including leuco dyes and mixtures thereof as described in U.S. Patent Nos. 3,427,161, 3,479,185, and 3,549,367 can be used as initiators. Also useful with photoinitiators and photoinhibitors are sensitizers disclosed in U.S. Patent No. 4,162,162. The photoinitiator or photoinitiator system is present in 0.05 to 10% by weight based on the total weight of a dry photopolymerizable layer.

### D. Solvents

The solvent component of the organic medium, which may be a mixture of solvents, is chosen so as to obtain complete solution therein of the polymer and other organic components. The solvent should be inert (non-reactive) towards the other constituents of the composition. For screen printable and photoimageable pastes, the solvent(s) should have sufficiently high volatility to enable the solvent to be evaporated from the dispersion by the application of relatively low levels of heat at atmospheric pressure, however, the solvent should not be so volatile that the paste rapidly dries on a screen, at normal room temperatures, during the printing process. The preferred solvents for use in the paste compositions should have boiling points at atmospheric pressure of less than 300°C and preferably less than 250°C. Such solvents include aliphatic alcohols, esters of such alcohols, for example, acetates and propionates; terpenes such as pine oil and alpha- or beta-terpineol, or mixtures thereof; ethylene glycol and esters thereof, such as ethylene glycol monobutyl ether and butyl cellosolve acetate; carbitol esters, such as butyl carbitol, butyl carbitol acetate and carbitol acetate and other appropriate solvents such as Texanol® (2,2,4-trimethyl-1,3-pentanediol monoisobutyrate). For casting tapes, the solvent(s) have lower boiling points than solvents used for screen printable pastes. Such solvents include ethylacetate, methanol, isoproanol, acetone, xylene, ethanol, methylethyl ketone and toluene.

### E. Other Additives

Frequently the organic medium will also contain one or more plasticizers. Such plasticizers help to assure good lamination to substrates and enhance the developability of unexposed areas of the composition. The choice of plasticizers is determined primarily by the polymer that must be modified. Among the plasticizers which have been used in various binder systems are diethyl phthalate, dibutyl phthalate, butyl benzyl phthalate, dibenzyl phthalate, alkyl phosphates, polyalkylene glycols, glycerol, poly (ethylene oxides), hydroxy ethylated alkyl phenol, tricresyl phosphate triethyleneglycol diacetate and polyester plasticizers. Additional components known in the art may be present in the composition including dispersants, stabilizers, release agents, dispersing agents, stripping agents, antifoaming agents and wetting agents. A general disclosure of suitable materials is presented in US Pat. No. 5,049,480.

### General Paste Preparation

Typically, thick film compositions are formulated to have a paste-like consistency, and are called "pastes". Generally, the pastes are prepared under yellow light by mixing the organic vehicle, monomer (s), and other organic components in a mixing vessel. The inorganic materials are then added to the mixture of organic components. The total composition is then mixed until the inorganic powders are wetted by the organic materials. The mixture is then roll milled using a three roll mill. The paste viscosity at this point could be adjusted with the appropriate vehicle or solvent to achieve a viscosity optimum for processing.

Care is taken to avoid dirt contamination in the process of preparing paste compositions and in preparing parts, since such contamination can lead to defects.

### General Firing Profile

The composition of the present invention may be processed by using a firing profile. Firing profiles are well within the knowledge of those skilled in the art of thick film technology. Removal of the organic medium and sintering of the inorganic materials is dependent on the firing profile. The profile will determine if the medium is substantially removed from the finished article and if the inorganic materials are substantially sintered in the finished article. The term "substantially" as used herein means at least 95% removal of the medium and sintering the inorganic materials to a point to provide at least adequate resistivity or conductivity for the intended use or application.

### General Tape Preparation

The composition of the present invention may be used in the form of a tape. If the composition is to be used in the form of a tape, a slip is prepared and used for tape casting. Slip is a general term used for the composition in tape making and is a properly dispersed mixture of inorganic powders dispersed in an organic medium. A common way of achieving a good dispersion of inorganic powders in the organic medium is by using a conventional ball-milling process. A ball milling consists of ceramic milling jar and milling media (spherical or cylindrical shaped alumina or zirconia pellets). The total mixture is put into the milling jar and the milling media are added. After closing the jar with a leak-tight lid, it is tumbled to create a milling action of the milling media inside the jar at a rolling speed at which the mixing efficiency is optimized. The length of the rolling is the time required to attain well dispersed inorganic particles to meet the performance specifications. The slip may be applied to a substrate by a blade or bar coating method, followed by ambient or heat drying. The coating thickness after drying may range from a few microns to several tens of microns depending on the application.

The tape may be laminated with a coversheet before it is wound as a widestock roll. Silicone coated terephthalate PET film, polypropylene, or polyethylene may be used as a coversheet. The coversheet is removed before laminated to the final substrate.

### TEST PROCEDURES

### Time to Clear

The time to clear (TTC) is defined as the time in which a photoimageable paste, coated or printed on a substrate, is completely removed by development using a conveyorized spray processor containing 0.5% by weight sodium carbonate in water, at ~30°C with a spray pressure of 10-20 psi. TTC is determined on a test part, after the paste has been printed and dried, but before exposure to the UV light.

### Line Resolution

Imaged samples are inspected using a zoom microscope at a minimum magnification of 20x with 10x oculars. The finest group of lines, which are completely intact without any, shorts (connections between the lines) or opens (complete breaks in a line), is the stated line resolution for that sample.

### Dry Sample Thickness

Printed samples are dried at 80°C for twenty minutes. Dried parts are scratched with a spatula. The thickness is measured at four different points using a contact profilometer, such as a Tencor Alpha Step 2000. Fired Sample Thickness

Printed and dried samples are fired using a 3 hour heating profile with a 10 min. peak at 520 °C. The thickness is measured at four different points using a contact profilometer.

### Color Measurement

Color is visually observed. The color is observed from the non-printed, glass side of the sample.

### EXAMPLES

### PREPARATION OF COMPOSITIONS

### A. Preparation of Organic Vehicle

The solvent and acrylic polymer were mixed and heated with stirring to 80°C. Heating and stirring was continued until the entire binder polymer had dissolved. The remaining organic components were added and the mixture was stirred at 80°C. until all the solids had dissolved. The solution was allowed to cool.

### B. Preparation of Glass Frit

The glass frit was used as available, or if necessary was prepared by water milling in a Sweco Mill using 0.5 in. diameter by 0.5 in. long alumina cylinders. The glass fit mixture was then either freeze dried or hot air dried. Hot air drying was normally done at a temperature of 150°C.

### C. Printing Conditions

The paste was applied to glass substrates by screen-printing using the screens as described below. The parts were dried at ~80°C for approximately 20 minutes in an air atmosphere oven.

The parts were tested as a two layer structure. The example black paste was first deposited on the glass substrate by screen-printing using a 355 mesh polyester screen. The parts were then dried at ~80°C in an air atmosphere oven for approximately 20 minutes. Next, the parts were overprinted with DuPont Fodel® DC206 photoimageable Ag conductor paste by screen printing using 325 stainless steel mesh screen. The parts were again dried at ~80°C for approx. 20 minutes in an air atmosphere oven. The dried coating thickness for the two layer structure was measured at 11-12 microns.

### D. Process Conditions

The parts were exposed through a phototool using a collimated UV light source. The energy level used was 600 mJ/sq. cm. The exposed parts were developed using a conveyorized spray processor containing 0.5% by weight sodium carbonate in water as the developer solution. The developer solution temperature was maintained at ~30°C, and the developer solution was sprayed at 10-20 psi. The developed parts were dried by blowing off the excess water with a forced air stream. The dried parts were then fired in an air atmosphere using a 3 hour profile with a 10 min peak temperature of 520°C.

### Explanation of Tables

Table 1 gives formulations for Examples 1-3.

Table 2 shows the testing results for the formulations in Table 1.

Example 1 is a composition without the UV-imageable polymer wherein imaged lines washed away during development. Examples 2 and 3 contain UV-imageable polymers showing high resolution lines and spaces retained through the development process.

All values given in Table 1 are in weight % based on total composition.

**Table 1**

| Examples | 1 | 2 | 3 |
|---|---|---|---|
| Formula | | | |
| | | | |
| Medium I | 43.23 | | |
| Medium II | | 43.23 | |
| Medium III | | | 43.23 |
| Glass Frit 1 | 9.61 | 9.61 | 9.61 |
| Monomer I | 2.11 | 2.11 | 2.11 |
| Oligomer | 8.45 | 8.45 | 8.45 |
| Malonic acid | 0.86 | 0.86 | 0.86 |
| Texanol | 6.72 | 6.72 | 6.72 |
| BHT | 0.19 | 0.19 | 0.19 |
| Glass Frit 2 & Pyrochlore | 28.82 | 28.82 | 28.82 |

**Table 2**

| Example | 1 | 2 | 3 |
|---|---|---|---|
| | | | |
| Line and space resolution (µm) | washed away | 40 | 30 |
| Dry sample thickness (µm) | 11.3 | 11.5 | 11.2 |
| Time to clear (second) | 6.5 | 6.5 | 6.2 |
| Exposure energy (mJ/cm2) | 600 | 600 | 600 |
| | | | |
| | | | |
| Fired sample thickness | Washed away | 3.8 | 3.2 |
| Color | Washed away | black | black |

### Glossary of Materials

### I. Inorganic materials

Frit 1: bismuth lead borosilicate glass; (component weight %), Bi₂O₃ (82), PbO (11), B₂O₃ (3.5), SiO₂ (3.5).

Frit 2:by weight, about 50% of a glass frit [(component weight %), SiO₂ (9.1), Al₂O₃ (1.4), PbO (77.0), B₂O₃ (12.5)] and ~ 50% lead bismuth ruthenium pyrochlore (PbBiRu₂O_{6.75}).

### II. Polymers

Polymer I: PVPNA S-630, a copolymer of 60% vinylpyrrolidone and 40% vinyl acetate. K-value = 30 - 50, purchased from ISP Technologies.

Polymer II: a copolymer of 75% methymethacrylate and 25% methacrylic acid, weight average molecular weight Mw = ~ 7,000, acid number = ~150, purchased from B.F. Goodrich.

Polymer III: Photocrosslinkable copolymer comprising methyl methacrylate 75% by weight with methacrylic acid 16% and 9 % methacrylic acid ester that was formed by the reaction of glycidyl methacrylate and methacrylic acid units on the starting polymer backbone. It had a glass transition temperature of 102°C and a weight average molecular weight of 6,500. The polymer chemical structure is as follows:

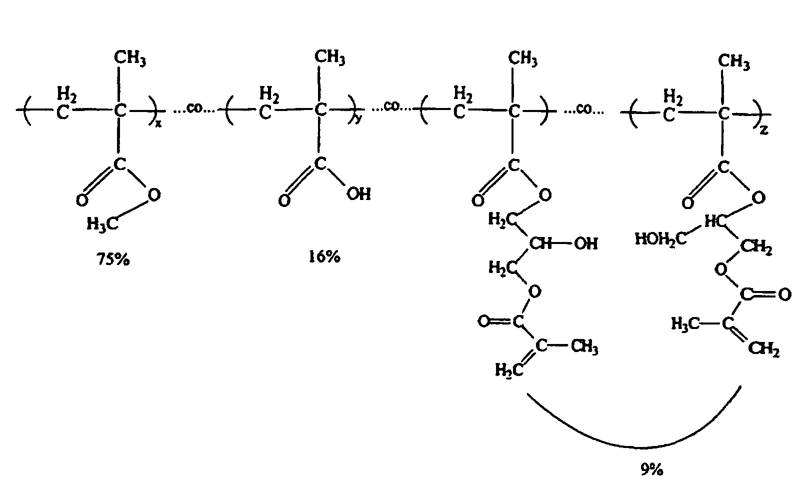

Polymer IV: Cyclomer-P(ACA) 2015TX, purchased from Diacel Chemical Industries, Japan.

### III. Other Organics

Monomer 1: SR-454 (Trimethylolpropane ethoxy triacrylate), purchased from Sartomer.

Oligomer: CN-138, a low viscosity acrylic oligomer mixed with methacrylate acid ester, acrylic ester and aromatic urethane acrylate Purchased from Sartomer.

Irgacure 651: 2,2-dimethoxy-2-phenylacetophenone, purchased from Ciba Specialty Chemicals.

Irgacure 369: 2-benzyl-2-(dimethylamino)-1-(4-morpholinophenyl)-1-butanone, purchased from Ciba Specialty Chemicals.

BHT: 2,6-di-tert-butyl-4-methylphenol purchased from Aldrich Chemicals.

TAOBN: 1,4,4-trimethyl-2, 3-diazabicyclo [3,2,2]-non-2-ene-N,N'-dioxide.

Texanol: 2,2,4-trimethyl-1,3-pentanediol monoisobutyrate purchased from Eastman Chemicals.

| Medium compositions | | | |
|---|---|---|---|
| | Medium Number | | |
| Component | I | II | III |
| Texanol | 65.4 | 65.4 | 65.4 |
| Polymer I | 1.53 | 1.53 | 1.53 |
| Polymer II | 36.4 | | |
| Polymer III | | | 36.14 |
| Polymer IV | | 36.14 | |
| TAOBN | 0.07 | 0.07 | 0.07 |
| Irgacure 651 | 4.86 | 4.86 | 4.86 |
| Irgacure 369 | 2.0 | 2.0 | 2.0 |

## Claims

1. A photoimageable composition comprising:
(I) finely divided particles of inorganic material comprising:
(d) conductive particles selected from RuO₂, ruthenium-based polynary oxides or mixtures thereof;
(e) inorganic binder having a glass transition temperature in the range of from 325 to 600°C, a surface area of no greater than 10 m²/g and at least 85 wt. % of the particles having a size in the range of 0.1-10 µm;
dispersed in:
(II) an organic medium comprising;
(c) aqueous developable photocrosslinkable polymer which is a copolymer, interpolymer or mixture thereof, wherein each copolymer or interpolymer comprises (1) a nonacidic comonomer comprising a C₁₋₁₀ alkyl acrylate, C₁₋₁₀ alkyl methacrylate, styrene, substituted styrene or combination thereof and (2) an acidic comonomer comprising ethylenically unsaturated carboxylic acid containing moiety, wherein 2-20% of the carboxylic acid containing moiety is reacted with a reactive molecule having a first and second functional unit wherein the first functional unit is a vinyl group and the second functional unit is capable of forming a chemical bond by reaction with the carboxylic acid moiety; forming the copolymer, interpolymer or mixture thereof having an acid content of at least 10 wt. % of the total polymer weight; a glass transition temperature in the range of 50-150°C and a weight average molecular weight in the range of 2,000-250,000;
(d) photoinitiation system; and
(f) organic solvent.

2. The composition of Claim 1 wherein the vinyl group is selected from a methacrylate, acrylate group and mixture thereof.

3. The composition of Claim 1 wherein the second functional unit is selected from an epoxide, alcohol, amine and mixture thereof.

4. The composition of Claim 1 wherein the inorganic material further comprises Au, Ag, Pd, Pt, Cu and mixture thereof.

5. The composition of Claim 1 wherein in organic medium further comprises photohardenable monomer.

6. The composition of Claim 1 which is in the form of a paste suitable for screen-printing.

7. A sheet comprising a layer of the composition of Claim 1 wherein the composition has been dried to remove the organic solvent.

8. An article comprising a layer of the composition of Claim 1 wherein the composition has been heated to substantially remove the organic medium and substantially sinter the inorganic material.

## Patentansprüche

1. Lichtoptische Bildaufzeichnungszusammensetzung, die aufweist:
(I) feinverteilte Teilchen aus anorganischem Material, die aufweisen:
(d) leitfähige Teilchen, die unter RuO₂, polynären Oxiden auf Rutheniumbasis oder deren Gemischen ausgewählt sind;
(e) ein anorganisches Bindemittel mit einer Glasübergangstemperatur im Bereich von 325 bis 600°C, einer spezifischen Oberfläche von nicht mehr als 10 m²/g und mindestens 85 Gew.-% der Teilchen mit einer Größe im Bereich von 0,1 - 10 µm; dispergiert in:
(II) einem organischen Medium; das aufweist:
(c) ein wässrig entwickelbares, photochemisch vernetzbares Polymer, das ein Copolymer, Mischpolymerisat oder ein Gemisch davon ist, wobei jedes Copolymer oder Mischpolymerisat aufweist: (1) ein nichtsaures Comonomer mit einem C₁₋₁₀-Alkylacrylat, C₁₋₁₀-Alkylmethacrylat, Styrol, substituiertem Styrol oder einer Kombination daraus, und (2) ein saures Comonomer mit einer ethylenisch ungesättigten carbonsäurehaltigen Komponente, wobei 2-20% der carbonsäurehaltigen Komponente mit einem reaktiven Molekül zur Reaktion gebracht wird, das eine erste und eine zweite funktionelle Einheit aufweist, wobei die erste funktionelle Einheit eine Vinylgruppe ist und die zweite funktionelle Einheit in der Lage ist, durch Reaktion mit der Carbonsäurekomponente eine chemische Bindung zu bilden; das Copolymer, Mischpolymerisat oder ein Gemisch daraus mit einem Säuregehalt von mindestens 10 Gew.-% des Gesamtgewichts des Polymers; einer Glasübergangstemperatur im Bereich von 50-150°C und einem massegemittelten Molekulargewicht im Bereich von 2.000-250.000 zu bilden;
(d) ein Photoinitiationssystem; und
(f) ein organisches Lösungsmittel.

2. Zusammensetzung nach Anspruch 1, wobei die Vinylgruppe unter einer Methacrylatgruppe, einer Acrylatgruppe und einem Gemisch daraus ausgewählt ist.

3. Zusammensetzung nach Anspruch 1, wobei die zweite funktionelle Einheit unter einem Epoxid, Alkohol, Amin und einem Gemisch daraus ausgewählt ist.

4. Zusammensetzung nach Anspruch 1, wobei das anorganische Material ferner Au, Ag, Pd, Pt, Cu und ein Gemisch daraus aufweist.

5. Zusammensetzung nach Anspruch 1, wobei das organische Medium ferner ein photochemisch härtbares Monomer aufweist.

6. Zusammensetzung nach Anspruch 1, die in Form einer Paste vorliegt, die sich zum Siebdruck eignet.

7. Folie, die eine Schicht aus der Zusammensetzung nach Anspruch 1 aufweist, wobei die Zusammensetzung getrocknet worden ist, um das organische Lösungsmittel zu entfernen.

8. Gegenstand, der eine Schicht aus der Zusammensetzung nach Anspruch 1 aufweist, wobei die Zusammensetzung erhitzt worden ist, um das organische Medium weitgehend zu entfernen und das anorganische Material im wesentlichen zu sintern.

## Revendications

1. Composition photo-imageable comprenant:
(I) des particules finement divisées d'un matériau inorganique comprenant:
(d) des particules conductrices sélectionnées parmi les suivantes: RuO₂, oxydes polynaires à base de ruthénium ou des mélanges de ceux-ci;
(e) un liant inorganique qui présente une température de transition vitreuse située entre 325 et 600°C, une aire de surface ne dépassant pas 10 m²/g et dont les dimensions de 85% en poids au moins des particules sont comprises entre 0,1 et 10 µm;
dispersées dans:
(II) un milieu organique comprenant:
(c) un polymère aqueux développable et photoréticulable qui est un copolymère, un interpolymère ou un mélange de ceux-ci, dans lequel chaque copolymère ou interpolymère comporte (1) un comonomère non acide comprenant un acrylate d'alkyle en C₁₋₁₀, un méthacrylate d'alkyle en C₁₋₁₀, un styrène, un styrène substitué ou une combinaison de ceux-ci et (2) un comonomère acide comprenant un fragment contenant un acide carboxylique à insaturation éthylénique, dans lequel on fait réagir de 2 à 20 % du fragment contenant un acide carboxylique à insaturation éthylénique avec une molécule réactive possédant une première et une seconde unités fonctionnelles, la première unité fonctionnelle correspondant à un groupement vinyle et la seconde unité fonctionnelle étant capable de former une liaison chimique par réaction avec le fragment à acide carboxylique pour former le copolymère, l'interpolymère ou le mélange de ceux-ci qui présente une teneur en acide de 10% en poids au moins du poids total du polymère, une température de transition vitreuse comprise entre 50 et 150°C et une masse moléculaire moyenne en poids comprise entre 2 000 et 250 000;
(d) un système de photoinitiation; et
(f) un solvant organique.

2. Composition selon la revendication 1, dans laquelle le groupement vinyle est sélectionné parmi un groupement méthacrylate, un groupement acrylate et un mélange de ceux-ci.

3. Composition selon la revendication 1, dans laquelle la seconde unité fonctionnelle est sélectionnée parmi un époxyde, un alcool, une amine et un mélange de ceux-ci.

4. Composition selon la revendication 1, dans laquelle le matériau inorganique comprend également Au, Ag, Pd, Pt, Cu et un mélange de ceux-ci.

5. Composition selon la revendication 1, dans laquelle le milieu organique comprend également un monomère photodurcissable.

6. Composition selon la revendication 1, qui est sous la forme d'une pâte qui se prête à la sérigraphie.

7. Feuillet comprenant une couche de la composition selon la revendication 1, dans laquelle la composition a été séchée pour éliminer le solvant organique.

8. Article comprenant une couche de la composition selon la revendication 1, ladite composition ayant été chauffée pour éliminer essentiellement tout le milieu organique et fritter essentiellement tout le matériau inorganique.
